# EUROPÄISCHE PATENTSCHRIFT

(11) **EP 1 269 809 B1**
(45) Veröffentlichungstag und Bekanntmachung des Hinweises auf die Patenterteilung: **13.10.2004**
(21) Anmeldenummer: 01917052.1
(22) Anmeldetag: 02.03.2001
(51) Int. Cl.: H05K 7/14

(54) **ELEKTRISCHES GERÄT MIT ANREIHBAREN MODULEN**
ELECTRIC APPLIANCE COMPRISING MODULES THAT CAN BE JUXTAPOSED
APPAREIL ELECTRIQUE COMPORTANT DES MODULES POUVANT ETRE MONTES L'UN A COTE DE L'AUTRE

(30) Priorität: 11.03.2000 DE 10011354
(43) Veröffentlichungstag der Anmeldung: 02.01.2003
(73) Patentinhaber: Hirschmann Electronics GmbH & Co. KG, 72654 Neckartenzlingen (DE)
(72) Erfinder: LIEB, Gerald, 71394 Kernen (DE); GAIDOSCH, Othmar, 73760 Ostfildern (DE); FISCHER, Bernd, 73207 Plochingen (DE)
(74) Vertreter: Stadler, Heinz, Dipl.-Ing.
(86) Internationale Anmeldenummer: PCT/EP2001/002355
(87) Internationale Veröffentlichungsnummer: WO 2001/069995

(56) Entgegenhaltungen:
- DE-A- 3 801 675
- DE-U- 29 607 525
- DE-U- 29 703 367

## Beschreibung

Die Erfindung betrifft ein elektrisches Gerät mit anreihbaren, durch Brückenglieder elektrisch miteinander verbindbaren Modulen gemäß dem Oberbegriff der Ansprüche 1 und 2.
Solche Geräte, wie sie beispielsweise aus der DE 297 03 367 U1 bekannt sind, werden häufig als Teilnehmergeräte in Bussystemen zur Steuerung und Überwachung technischer Prozesse eingesetzt, wobei Sensoren und Aktoren über Gerätesteckverbinder an die Module anschließbar sind.

Zur Abdichtung der Verbindungsstelle zwischen Brückengliedem und Modulen sind bei dem genannten Stand der Technik die ineinandergreifenden Teile formschlüssig ausgebildet. Eine derartige Ausführung bedingt jedoch durch die erforderliche Fertigungsgenauigkeit hohe Herstellungskosten. Trotzdem ist die erzielbare Dichtwirkung gering. Zu deren Verbesserung ist daher bei dem bekannten Gerät eine zusätzliche Dichtung, z.B. eine Flachdichtung, wie sie auch bei dem aus der DE 296 07 525 U1 bekannten Gerät eingesetzt ist, vorgesehen, die beim Einstecken der Brückenglieder in die Module in Steckrichtung gegen das als Kontaktträger dienende Bodenteil von Sack-Ausnehmungen im Modulgehäuse gedrückt werden. Zur Erzeugung des hierfür erforderlichen Drucks sind bei dem bekannten Gerät Gewindeschrauben vorgesehen, die Bohrungen der Brückenglieder durchsetzen und in Gewindebohrungen der Modulgehäuse eindrehbar sind. Ohne diese Schraubbefestigung wären die Brückenglieder, insbesondere bei einer Verwendung solcher Geräte an Maschinen, überdies nicht lagestabil und die Kontaktierung der Steckverbindungen nicht rüttelsicher.

Aufgabe der Erfindung ist es daher, ein elektrisches Gerät der eingangs genannten Art zu schaffen, bei dem auf möglichst einfache und kostensparende Weise die Verbindungsstellen zwischen Brückengliedern und Modulen eine auch hohen Anforderungen (Schutzart IP 67) genügende Dichtigkeit aufweisen und ohne zusätzliche Befestigungsmittel eine möglichst hohe Abziehkraft sowie eine rüttelsichere Kontaktierung der Steckverbinder gewährleistet ist.

Diese Aufgabe ist durch die kennzeichnenden Merkmale des Anspruches 1 oder des alternativen Aufbaus gemäß Anspruch 2 gelöst.
Durch die zylindrische Ausbildung der Durchführungen können als Dichtmittel ebenso kostengünstige wie wirksame O-förmige Dichtringe verwendet werden, die ihre im wesentlichen in radialer Richtung wirkende Dichtkraft bei gegebenem gegenseitigen Abstand der Anlageflächen allein durch ihre Abmessungen und Materialeigenschaften erreichen und keinerlei zusätzliche Maßnahmen, etwa zum Zusammenpressen, oder Einrichtungen wie beispielsweise Anlageflächen als Widerlager, benötigen. Außerdem sind sie äußerst einfach durch Aufschieben auf die Außenhülsen der Steckverbinder bzw. (bei einer Ausführung nach Anspruch 2) der Gegensteckverbinder montierbar und nicht, wie bei dem aus der DE 297 03 367 U1 bekannten Gerät, auf komplizierte Weise in eine Sack-Ausnehmung bzw. in Nuten des Bodenteils dieser Sack-Ausnehmungen einzubringen.
Darüber hinaus sind die Durchführungen erheblich kostengünstiger herstellbar als Sack-Ausnehmungen. Vor allem aber können die Durchführungen und die zugehörigen Kontaktträger an getrennten Teilen des elektrischen Gerätes angeordnet sein, wodurch sowohl die Fertigung als auch die Montage erheblich vereinfacht und ein vielseitiger Einsatz ermöglicht ist. Die Durchführungen sind gemäß den Alternativen nach Anspruch 1 und 2 entweder in den Modulgehäusen oder in den Brückengliedern angebracht, die zugehörigen Kontaktträger davon unabhängig etwa auf Schaltungsplatinen innerhalb der Module oder Brückenglieder.
Weiterhin weisen die den O-förmigen Dichtring tragenden Außenhülsen auch keinen Formschluss mit den Wandungen der Durchführungen auf, wodurch die Herstellung erheblich vereinfacht und kostengünstiger ist.

Die Klemmkraft des Dichtringes ist bei entsprechender Materialwahl und Bemessung der Abstände der Anlageflächen so groß, dass Steck- und Ziehkräfte von bis zu 10 kg erreicht werden und damit in der Regel keine besonderen zusätzlichen Mittel zur Befestigung der Brückenglieder erforderlich sind. Dies hat nicht nur den Vorteil einer weiteren wesentlichen Verringerung der Herstell- und Montagekosten, sondern auch einer leichten Handhabbarkeit, da die Brückenglieder, etwa zum Austausch von Modulen im Servicefall, von Hand aufsteckbar und abziehbar sind.

In den Unteransprüchen sind vorteilhafte Ausführungen und Weiterbildungen des elektrischen Gerätes nach den Ansprüchen 1 und 2 aufgeführt.

So stellt eine Ausführung nach Anspruch 3 ohne zusätzliche Dichtmittel die Dichtheit auch an den Einführungsstellen der Außenhülse in die jeweilige Durchführung sicher.

Durch eine schräge Anordnung der Anlageflächen für den O-förmigen Dichtring gemäß Anspruch 4 ist ohne irgendwelche Mehrkosten eine von dessen Beschaffenheit und den relevanten Abmessungen unabhängige Erhöhung der Steck- und Abziehkräfte auf bis zu etwa 15 kg erzielbar, weil die senkrecht zu den Anlageflächen gerichtete Klemmkraft des Dichtrings durch die Neigung der Anlageflächen eine Komponente in Einsteckrichtung erhält. Aufgrund dieser hohen Abziehkraft einerseits und der vibrationsdämpfenden Wirkung des elastischen Dichtrings andererseits ist das elektrische Gerät selbst für die Anbringung an der Unterseite von Montageflächen an stark rüttelnden Maschinen ohne zusätzliche Befestigungseinrichtungen geeignet.

Eine Ausführung der Modulgehäuse nach Anspruch 5 und eine Anordnung gegebenenfalls vorhandener Steckanschlüsse für Aktoren, Sensoren und einen Feldbus nach Anspruch 6 ermöglicht ein sehr kompaktes Gerät mit geringer Bauhöhe, das auch in den vielen Anwendungsfällen mit kleinem für die Montage zur Verfügung stehenden Raum einsetzbar ist.

Durch die in Anspruch 7 vorgesehene Trennwand mit Quersteg ist erforderlichenfalls ein Halt für die Brückenglieder gegen ein in Extremfällen oder bei unbeabsichtigtem Dagegenstoßen mögliches leichtes Kippen erreicht, so dass auch für diese Fälle eine sichere Dichtung und hohe Abziehkraft gewährleistet ist. Die Abmessungen sind dabei so gewählt, dass die angeführte Kompaktheit der Modulgehäuse erhalten bleibt. Diese Ausgestaltung ist praktisch ohne Mehrkosten durch eine einstückige Herstellung realisierbar (Anspruch 8).

In Anspruch 9 ist eine weitere sehr einfache und zweckmäßige Ausgestaltung des erfindungsgemäßen Gerätes angegeben, mit deren Hilfe die Module von Hand aneinander befestigbar (und bei Bedarf voneinander lösbar) sind. Die exakte Führung der Nasen in den Schlitzen gewährleistet darüber hinaus, dass der Mittenabstand der einander zugewandten Gegensteckverbinder benachbarter Module stets genau demjenigen der Steckverbinder der Brückenglieder entspricht, wodurch ein genau zentrisch axiales Einstecken der Steckverbinder in die Durchführungen und damit eine optimale Dicht- und Haltewirkung gewährleistet ist.

Eine pultförmige Ausführung der Modulgehäuse gemäß Anspruch 10 weist den Vorteil auf, dass die auf der schrägen Pultfläche positionierten Beschriftungsfelder und Anzeigeelemente sowohl bei Anordnung auf oder unter etwa waagrechten Flächen, sondern auch bei Wandmontage gut sichtbar sind. Dies um so mehr, wenn alle Beschriftungsfelder und Anzeigeelemente auf der schrägen Pultfläche angeordnet sind (Anspruch 11).

Bei einer Ausführung der Modulgehäuse nach Anspruch 12 besteht zwischen Gehäuseboden und Montagefläche ein Spalt, durch den hindurch eine Luftströmung (Konvektionsströmung) erfolgt, die in vorteilhafter Weise die von den gekapselten Modulen abgegebene Verlustwärme abführt. Im Vergleich zum Stand der Technik gemäß den deutschen Gebrauchsmustern 296 07 525 und 297 03 367, bei denen die Module ohne Abstand auf den Montageblechen angeordnet sind, ist die Betriebstemperatur bei dem erfindungsgemäß ausgebildeten Gerät niedriger und damit die Lebensdauer der Module erhöht.
Besonders kostengünstig ist es, nach Anspruch 13 die Füße mit dem Modulgehäuse, etwa im Spritzgußverfahren, einstückig herzustellen und zugleich mit Löchern zur Schraubbefestigung der Module zu versehen.
Die Konvektionsströmung zwischen Gehäusebohrung und Montagefläche und damit auch die Wärmeabfuhr ist besonders stark, wenn der Gehäuseboden gemäß Anspruch 14 ausgebildet ist.
Eine weitere Verstärkung der Kühlung der Module ist nach den Ansprüchen 15 und 16 dadurch erreichbar, dass der Gehäuseboden eine möglichst große Oberfläche zur Wärmeabgabe aufweist, wozu insbesondere rohrförmige Dome geeignet sind. Die Querschnitte der Dome können dabei beliebig, beispielsweise quadratisch oder rund ausgeführt sein.
Eine rasterförmige Anordnung dieser Dome, durch die in Strömungsrichtung verlaufende Schneisen zwischen den Domen gebildet sind, erleichtert überdies die Abfuhr der unerwünschten Verlustwärme.
Eine einstückige Ausbildung der Dome und des Gehäusebodens gemäß Anspruch 17 vermindert nicht nur die Herstellkosten, sondern gewährleistet auch eine optimale Wärmeübertragung vom Gehäuseboden auf die Dom-Oberflächen.

Insgesamt ist durch die Merkmale der Ansprüche 12 bis 17 eine merkliche Verlängerung der Geräte-Lebensdauer erreicht.

Es ist zweckmäßig, für interne Leitungsverbindungen und die Aufnahme elektrischer Schaltelemente eine Schaltungsplatine zu verwenden (Anspruch 18), die gemäß Anspruch 19 auf sehr einfache und kostengünstige Weise im Modulgehäuse befestigt sein kann.
Aufgrund der durch die erfindungsgemäß vorgesehenen Durchführungen ermöglichten Trennung dieser Durchführungen von den zugeordneten Gegensteckverbindern bzw. Steckverbindern, können diese nach Anspruch 17 auf der Schaltungsplatine angebracht und dabei ihre Kontaktelemente ohne zusätzliche Verbindungsleitungen direkt an die zugehörigen Leiterbahnen der Schaltungsplatine angeschlossen werden.

Bei einer vorteilhaften Weiterbildung der Brückenglieder gemäß Anspruch 20 ist eine von den Busleitungen unabhängige Einspeisung von Betriebsspannung in die Module ermöglicht. Die Leiterquerschnitte sind damit den im Einzelfall gewünschten Speiseströmen anpassbar. Beispielsweise sind sie für so hohe Ströme ausgelegt, dass eine Vielzahl von Sensoren und insbesondere Aktoren versorgt werden können. Dies ist bei der Übertragung von Betriebsspannung über Busleitungen nicht möglich, weshalb z.B. bei dem aus der DE 296 07 525 U1 bekannten Gerät ein zusätzlicher Einspeise-Baustein AS1 eingesetzt ist. Bei Verwendung von erfindungsgemäßen Brückengliedern nach Anspruch 20 ist eine solche zusätzliche Einrichtung nicht erforderlich.

In vielen Anwendungsfällen sind für einzelne Aktoren und Gruppen von Aktoren getrennte Betriebsspannungskreise erwünscht, etwa wenn die Betriebsspannung für bestimmte Aktoren im Gefahrenfall notausschaltbar sein soll ohne die übrigen Teilnehmer über die Busleitung zu beeinflussen. Dies ist durch eine Ausbildung der Brückenglieder nach Anspruch 21 auf einfache und kostensparende Weise ermöglicht, die jeweils an den betreffenden Modulen eingesteckt werden. Mit diesen Brückengliedern ist somit eine flexible Anpassung an die unterschiedlichen Bedürfnisse des Einzelfalls hinsichtlich der Betriebsspannungsversorgung erzielt. Demgegenüber ist bei den bekannten Geräten lediglich die Versorgung aller Aktoren und Sensoren zugleich möglich.

Die Erfindung ist nachstehend anhand eines Ausführungsbeispiels in Form einer Feldbus-Teilnehmereinheit gemäß der in Anspruch 1 angegebenen Alternative in den Figuren erläutert. Es zeigen:
Figur 1 - eine perspektivische Ansicht der Feldbus-Teilnehmereinheit,
Figur 2 - eine perspektivische Ansicht eines Einzelmoduls ohne sichtbaren Gegensteckverbinder,

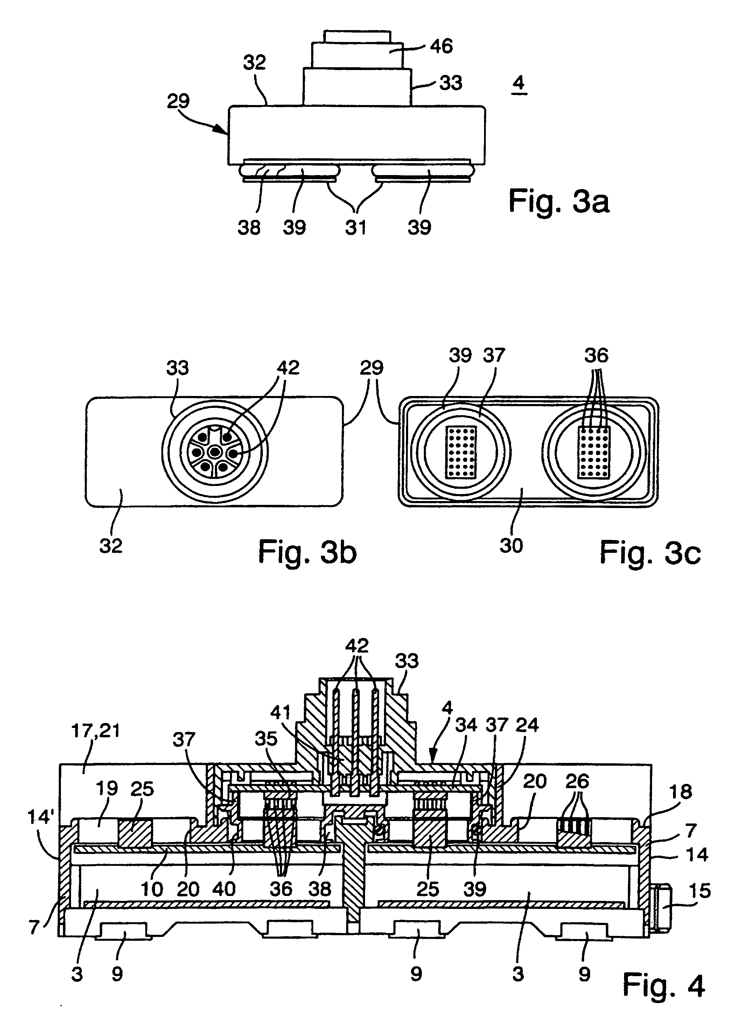

Figur 3 - eine seitliche Ansicht (Figur 3a), eine Draufsicht auf die Einspeiseseite (Figur 3b) sowie eine Draufsicht auf die Steckseite (Figur 3c) eines Brückengliedes und
Figur 4 - einen Schnitt durch zwei mit einem Brückenglied verbundene Module.

Die Feldbus-Teilnehmereinheit 1 besteht aus einem Feldbus-Anschlussmodul 2 und vier I/O(Input/Output)-Modulen 3 zur Steuerung und Überwachung von nicht dargestellten Aktoren und Sensoren, die miteinander und mit dem Feldbus Anschlussmodul 2 durch interne Signal- und Betriebsspannungsleitungen über Brückenglieder 4 elektrisch miteinander verbunden sind und Steckanschlüsse 5 zum Verbinden mit den Aktoren und Sensoren aufweisen.

Das Feldbus-Anschlussmodul 2 ist über zwei Steckverbindungen 6 in den Feldbus eingeschaltet und leitet einerseits die von den I/O-Modulen 3 über die internen Signalleitungen erhaltenen Sensorsignale an den Feldbus weiter und führt andererseits aus dem Feldbus ausgekoppelte Steuersignale über die I/O-Module 3 den Aktoren zu.

Die I/O-Module 3 weisen ein pultförmiges Modulgehäuse 7 mit Gehäuseboden 8 und Füßen 9 sowie eine Schaltungsplatine 10 auf, welche die Steckanschlüsse 5 trägt, die ihrerseits Ausnehmungen 11 der Dachfläche 12 des Modulgehäuses 7 durchsetzen und mit dieser etwa bündig sind. Auf der Pultfläche 13 sind sämtliche Beschriftungsfelder 42 und LED-Anzeigeelemente 43 der Module 2, 3 angeordnet.
An einer Seitenwand 14 weisen die Modulgehäuse 7 und das Feldbus-Anschlussmodul 2 zwei im Querschnitt T-förmige Nasen 15 und in der gegenüberliegenden Seitenwand 14' der I/O-Module 3 daran angepasste, oben offene Führungsschlitze 16 auf. Durch Einschieben der Nasen 15 eines Modulgehäuses 7 in die Führungschlitze 16 des benachbarten Modulgehäuses 7 sind die I/O-Module 3 und das Feldbus-Anschlussmodul 2 von Hand aneinander reihbar.
Auf der der Pultfläche 13 gegenüberliegenden Stirnseite weisen die Modulgehäuse 7 einen Absatz 17 auf, in dessen Grundfläche 18 zwei kragenformige Durchführungen 19 mit zylindrischer Wandung 20 angeordnet sind. Mittig zwischen den Durchfüh rungen 19 jedes Moduls 3 ist zwischen der Stirnfläche 21 des Absatzes 17 und einem mit der anschlussseitigen Stirnfläche 22 des Modulgehäuses 7 bündigen Quersteg 23 eine Trennwand 24 vorgesehen, wobei die Höhe des Querstegs 23 und der Trennwand 24 derjenigen der Stirnfläche 21 entspricht.

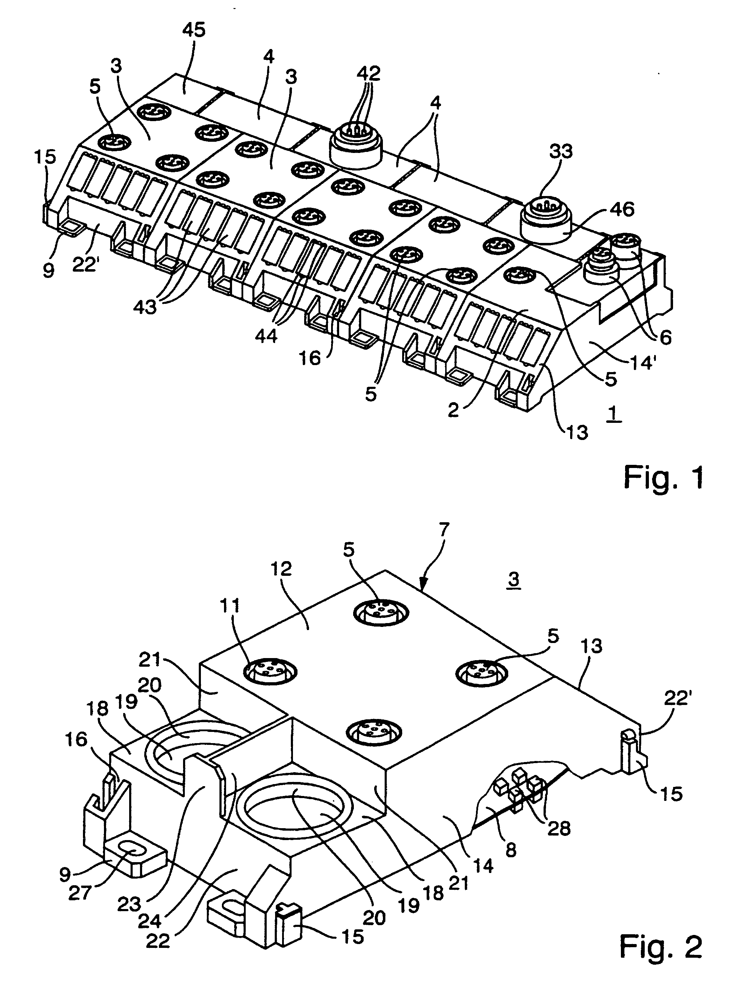

Auf der Schaltungsplatine 10 sind zwei in Figur 2 nicht dargestellte Kontaktträger 25 mit jeweils achtundzwanzig Steckbuchsen 26 angeordnet, die an zugehörige Anschlusspunkte bzw. Leiterbahnen der Schaltungsplatine 10 angeschlossen und im Bereich der Durchführungen 19 positioniert sind.

Die Füße 9, die zur gegebenenfalls benötigten Schraubbefestigung der Modulgehäuse 7 Langlöcher 27 aufweisen, stehen auf der Gehäuseunterseite vor, so dass zwischen dem Gehäuseboden 8 und der Montagefläche ein Zwischenraum besteht, in dem eine Luftströmung entsteht, durch die die in den gekapselten I/O-Modulen 3 und dem Feldbus-Anschlussmodul 2 entstehende Verlustwärme zu einem großen Teil abgeführt wird. Diese vorteilhafte Wirkung ist noch dadurch verstärkt, dass der Gehäuseboden 8 wannenförmig ausgebildet ist, wobei er sich zu den Stirnseiten des Moduls 2,3 hin verjüngt und rasterartig angeordnete Dome 28 aufweist, aufgrund deren großer Oberfläche eine hohe Wärmemenge abführbar ist.

Die Brückenglieder 4 weisen jeweils einen quaderförmigen Gehäusekörper 29 sowie zwei an der Basisfläche 30 vorgesehene 28-polige Steckverbinder 31 auf, wobei deren Zentrumsabstand und derjenige zwischen den einander zugewandten Durchführungen 19 zweier benachbarter I/O-Module 3 gleich groß sind. Bei zwei der vier Brückenglieder 4 sind darüber hinaus 6-polige Gerätesteckverbinder 33 vorgesehen.

Die Abmessungen der Gehäusekörper 29 entsprechen denen des Raumes zwischen den Trennwänden 24 zweier benachbarter Module 2,3 sowie zwischen den Querstegen 23 und den Stimflächen 21 der Absätze 17, wobei die Deckflächen 32 bei eingesteckten Brückengliedern 4 mit den Dachflächen 12 der Modulgehäuse 7 bündig sind.

Die Steckverbinder 31 bestehen jeweils aus einem mit einer Leiterplatte 34 integrierten Träger 35 zur Aufnahme der mit den Steckbuchsen 26 korrespondierenden achtundzwanzig Steckerstiften 36 und einer diese umfassenden, im wesentlichen zylindrischen Außenhülse 37, die in einer ringförmige Vertiefung 38 der Mantelfläche einen O-förmigen Dichtring 39 trägt.
Die Innenwand 40 der Vertiefung 38 sowie die dazu parallele Durchführungswandung 20 im Modulgehäuse 7 sind zur Steckachse unter einem Winkel von etwa 10° geneigt. Diese Neigung bewirkt eine Kraftkomponente in Einsteckrichtung, so dass zusammen mit einer entsprechenden Bemessung des gegenseitigen Abstandes der Anlageflächen 20, 40 und des Dichtrings 39 sowie dessen Materialeigenschaften insgesamt eine hohe Abziehkraft von etwa 15 kg erreicht ist, durch die eine Montage der Feldbus-Teilnehmereinheit 1 auch an stark vibrierenden Teilen etwa von Maschinen ohne zusätzliche Befestigungsmittel ermöglicht ist.

Die Gerätestecker 33 weisen jeweils sechs auf der Leiterplatte 34 mit weiterführenden Leiterbahnen verlötete in einem Isolierteil 41 gehaltene Kontaktstifte 42 auf, die von einem mit dem Gehäusekörper 29 und dem Isolierteil 41 einstückigen nach außen abragenden Kragen 46 umfasst sind.

Beim Aufbau der Feldbus-Teilnehmereinheit 1 werden zunächst das Feldbus-Anschlussmodul 2 und die I/O-Module 3 durch Einführen der an den Seitenwänden 14 angebrachten T-förmigen Nasen 15 bis zum Anschlag in die an den Seitenwänden 14' befindlichen Führungsschlitze 16 aneinander gereiht und bei Bedarf mit den Füßen 9 an der Montagefläche angeschraubt.
Dadurch sind die Modulgehäuse 7 in Sollposition lösbar aneinander befestigt, wobei durch die exakte, nahezu spielfreie Führung vor allem der genaue Sollabstand der einander zugewandten Durchführungen 19 benachbarter Modulgehäuse 7 gewährleistet ist, so dass die Steckverbinder 31 beim anschließenden Einstecken der Brückenglieder 4 in die Gegensteckverbinder 25, 26 nicht verkanten bzw. schräg zur Steckachse eingesteckt werden können. Dadurch werden die Dichtringe 38 am ganzen Umfang gleichmäßig gegen die Wandungen 20 der Durchführungen 19 gepresst, wodurch stets die maximale Dichtwirkung erzielt ist.

Bei dem am Ende der Feldbus-Teilnehmereinheit 1 angeordneten I/O-Modul 3 wird der nicht durch ein Brückenglied weiterverbundene letzte Gegensteckverbinder durch eine Blindkappe 45 abgedeckt.

Die internen, mit den Steckanschlüssen 5 der Aktoren und Sensoren verbundenen Signalleitungen (Leiterbahnen auf den Schaltungsplatinen 10) werden über die Steckbuchsen 26 der Gegensteckverbinder, die Steckerstifte 36 der Steckverbinder 31 sowie Leiterbahnen auf der Schaltungsplatine 10 und der Leiterplatte 34 durch die I/O-Module 3 durchgeschleust und dem Feldbus-Anschlussmodul 2 zugeführt.

Zwei der vier I/O-Module 3 weisen einen Gerätesteckverbinder 33 auf, durch die über jeweils einen der Steckverbinder 31 der Brückenglieder 4 die Betriebsspannung insbesondere für die Aktoren in zwei voneinander getrennte, jeweils zwei I/O-Module 3 umfassende Aktorenkreise eingespeist werden, die damit in Notfällen getrennt abschaltbar sind.
Die Kontaktstifte 42 der Gerätestecker 33 sind im vorliegenden Fall für Ströme von 8 A ausgelegt. Zu deren störungsloser Weiterleitung zu den Aktoren sind jeweils mehrere Leiterbahnen der Leiterplatte 34 und der Schaltungsplatine 10 sowie mehrere der dünnen Steckerstifte 36 und Steckbuchsen 26 parallel geschaltet.

Schließlich werden noch die Sensoren und Aktoren an den Steckanschlüssen 5 des Feldbus-Anschlussmoduls 2 und der I/O-Module 3 angeschlossen und das Feldbus-Anschlussmodul 2 mit Hilfe der Steckverbindungen 6 in den Feldbus eingeschaltet. Mit dieser einfachen und schnellen Montage ist die Feldbus-Teilnehmereinheit 1 funktionsfähig. Aber auch ein Auswechseln von Modulen, etwa im Servicefall oder zur Anpassung der gesamten Einheit an geänderte Anforderungen, ist bei der erfindungsgemäß aufgebauten Feldbus-Teilnehmereinheit 1 im Gegensatz zu der aus der DE 296 97 525 U1 bekannten Geräteeinheit unabhängig von der Lage des Einzelmoduls im gesamten Verbund besonders einfach möglich. Lediglich durch Abziehen zweier Brückenglieder 4 (beim letzten I/O-Modul 3 der Einheit nur eines Brückengliedes 4) von Hand und gegebenenfalls Lösen der Schraubverbindungen an den Modulfüßen 9 kann jedes beliebige Einzelmodul aus dem Verbund herausgenommen und ebenso schnell ersetzt werden.

### Bezugszeichenliste

- 1 -: Feldbus-Teilnehmereinheit
- 2 -: Feldbus-Anschlussmodul
- 3 -: I/O-Module
- 4 -: Brückenglieder
- 5 -: Steckanschlüsse
- 6 -: Steckverbindungen
- 7 -: Modulgehäuse
- 8 -: Boden des Modulgehäuses 7
- 9 -: Füße des Modulgehäuses 7
- 10 -: Schaltungsplatine
- 11 -: Ausnehmungen
- 12 -: Dachfläche des Modulgehäuses 7
- 13 -: Pultfläche des Modulgehäuses 7
- 14, 14' -: Seitenwände des Modulgehäuses 7
- 15 -: Nasen
- 16 -: Führungsschlitze
- 17 -: Absatz des Modulgehäuses 7
- 18 -: Grundfläche des Absatzes 17
- 19 -: Durchführungen
- 20 -: Wandung der Durchführungen 19
- 21 -: Stirnfläche des Absatzes 17
- 22, 22' -: Stirnflächen des Gehäuses 7
- 23 -: Quersteg
- 24 -: Trennwand
- 25 -: Kontaktträger
- 26 -: Steckbuchsen
- 27 -: Langlöcher der Füße 9
- 28 -: Dome des Gehäusebodens 8
- 29 -: Gehäusekörper
- 30 -: Basisfläche des Gehäusekörpers 28
- 31 -: Steckverbinder
- 32 -: Deckfläche des Gehäusekörpers 28
- 33 -: Gerätestecker
- 34 -: Leiterplatte der Brückenglieder 4
- 35 -: Kontaktträger
- 36 -: Steckerstifte
- 37 -: Außenhülse
- 38 -: Vertiefung
- 39 -: Dichtring
- 40 -: Innenwand der Vertiefung 38
- 41 -: Isolierteil
- 42 -: Kontaktstifte
- 43 -: Beschriftungsfelder
- 44 -: LED-Anzeigeelemente
- 45 -: Blindkappe
- 46 -: Kragen des Gerätesteckers 33

## Patentansprüche

1. Elektrisches Gerät, insbesondere Feldbus-Teilnehmereinheit (1) mit Steckanschlüssen (5, 6) für Aktoren und/oder Sensoren sowie den Feldbus, bestehend aus anreihbaren, ein Gehäuse (7) aufweisenden Modulen (2, 3), die durch Brückenglieder (4) zur Übertragung von elektrischen Signalen und Betriebsspannung miteinander verbindbar sind, wobei jedes Brückenglied (4) zwei Steckverbinder (31) und jedes Modul (2, 3) zwei, bei Endgeräten wahlweise auch nur einen, Gegensteckverbinder (25, 26) aufweist und die Steckverbinder (31) jedes Brückengliedes (4) in die beiden einander zugewandten Gegensteckverbinder (25, 26) zweier nebeneinander angeordneter Module (2, 3) einsteckbar sind, **dadurch gekennzeichnet, dass** den Gegensteckverbindern (25, 26) jeweils eine zylindrische Durchführung (19) des Modulgehäuses (7) zugeordnet ist und die Steckverbinder (31) jeweils eine im wesentlichen zylindrische Außenhülse (37) aufweisen, an deren Umfang ein O-förmiger Dichtring (39) in einer ringförmigen Vertiefung (38) angeordnet ist, welcher bei eingestecktem Steckverbinder (31) unter Druck an der Wandung (20) der Durchführung (19) anliegt.

2. Elektrisches Gerät, insbesondere Feldbus-Teilnehmereinheit (1) mit Steckanschlüssen (5, 6) für Aktoren und/oder Sensoren sowie den Feldbus, bestehend aus anreihbaren, ein Gehäuse (7) aufweisenden Modulen (2, 3), die durch Brückenglieder (4) zur Übertragung von elektrischen Signalen und Betriebsspannung miteinander verbindbar sind, wobei jedes Brückenglied (4) zwei Steckverbinder (31) und jedes Modul (2, 3) zwei bei Endgeräten wahlweise auch nur einen , Gegensteckverbinder (25, 26) aufweist und die Steckverbinder (31) jedes Brückengliedes (4) in die beiden einander zugewandten Gegensteckverbinder (25, 26) zweier nebeneinander angeordneter Module (2, 3) einsteckbar sind, **dadurch gekennzeichnet, dass** den Steckverbindern jeweils eine zylindrische Durchführung des Brückengliedes zugeordnet ist und die Gegensteckverbinder jeweils eine im wesentlichen zylindrische Außenhülse aufweisen, an deren Umfang ein O-förmiger Dichtring in einer ringförmigen Vertiefung angeordnet ist, welcher bei eingestecktem Steckverbinder unter Druck an der Wandung der Durchführung anliegt.

3. Elektrisches Gerät nach Anspruch 1 oder 2, **dadurch gekennzeichnet, dass** die Außenhülse (37) mit dem Brückenglied (4) bzw. dem Modulgehäuse (7) einstückig ist.

4. Elektrisches Gerät nach einem der Ansprüche 1 bis 3, **dadurch gekennzeichnet, dass** die einander gegenüberliegenden, zueinander etwa parallelen Dichtring-Anlageflächen (20, 40) der Durchführung (19) und der ringförmigen Vertiefung (38) gegen die Steckachse geneigt sind.

5. Elektrisches Gerät nach einem der Ansprüche 1 bis 4, **dadurch gekennzeichnet, dass** das Modulgehäuse (7) einen Absatz (17) aufweist, in dessen Grundfläche (18) die Durchführungen (19) oder - bei einer Ausbildung gemäß Anspruch 2 - die Außenhülsen angeordnet sind, dessen Höhe dem von der Grundfläche (18) abragenden Teil der eingesteckten Brückenglieder (4) und dessen Tiefe etwa derjenigen der Brückenglieder (4) entspricht.

6. Elektrisches Gerät nach einem der Ansprüche 1 bis 5, **dadurch gekennzeichnet, dass** Steckanschlüsse (5, 6) für Aktoren, Sensoren und Feldbus im Modulgehäuse (7) versenkt oder zumindest in etwa mit dessen Dachfläche (12) bündig sind.

7. Elektrisches Gerät nach einem der Ansprüche 5 oder 6, **dadurch gekennzeichnet, dass** das Modulgehäuse (7) im Bereich des Absatzes (17) mittig zwischen den Durchführungen (19) bzw. - bei einer Ausführung nach Anspruch 2 - den Außenhülsen eine Trennwand (24) und einen quer dazu verlaufenden, mit der anschlussseitigen Stirnfläche (22) des Modulgehäuses (7) bündigen, die Trennwand (24) seitlich etwas überragenden Quersteg (23) aufweist, wobei die Höhe des Quersteges (23) und der Trennwand (24) höchstens so groß ist wie diejenige des Absatzes (17).

8. Elektrisches Gerät nach Anspruch 7, **dadurch gekennzeichnet, dass** der Quersteg (23) und die Trennwand (24) mit dem Modulgehäuse (7) einstückig sind.

9. Elektrisches Gerät nach einem der Ansprüche 1 bis 8, **dadurch gekennzeichnet, dass** die Modulgehäuse (7) an den gegenüberliegenden Seitenwänden (14, 14') T-förmige Nasen (15) bzw. korrespondierende, zur Dachfläche (12) des Modulgehäuses (7) hin offene Führungsschlitze (16) zur wenigstens näherungsweise spielfreien Aufnahme der Nasen (15) aufweisen.

10. Elektrisches Gerät nach einem der Ansprüche 1 bis 9, **dadurch gekennzeichnet, dass** auf der dem Absatz (17) gegenüberliegenden Stirnseite der Modulgehäuse (7) eine pultförmig abgeschrägte Fläche (13) zur Aufnahme von Beschriftungsfeldem (43) und Anzeigelementen (44) vorgesehen ist.

11. Elektrisches Gerät nach Anspruch 10, **dadurch gekennzeichnet, dass** sämtliche Beschriftungsfelder (43) und Anzeigeelemente (44) auf der abgeschrägten Fläche (13) angeordnet sind.

12. Elektrisches Gerät nach einem der Ansprüche 1 bis 11, **dadurch gekennzeichnet, dass** das Modulgehäuse (7) Füße (9) zur Auflage auf einer Montagefläche aufweist, deren Auflagefläche vom Gehäuseboden (8) beabstandet ist.

13. Elektrisches Gerät nach Anspruch 12, **dadurch gekennzeichnet, dass** die Füße (9) mit dem Modulgehäuse (7) einstückig und mit Durchbrüchen (27) für Befestigungsschrauben versehen sind.

14. Steckverbinder nach Anspruch 12 oder 13, **dadurch gekennzeichnet, dass** der Gehäuseboden (8) wannenförmig ausgebildet ist und sich zu den Stirnflächen (22, 22') des Modulgehäuses (7) hin verjüngt.

15. Elektrisches Gerät nach einem der Ansprüche 1 bis 14, **dadurch gekennzeichnet, dass** der Gehäuseboden (8) rasterförmig angeordnete Erhebungen (Dome) (28) aufweist.

16. Elektrisches Gerät nach Anspruch 15, **dadurch gekennzeichnet, dass** die Dome (28) rohrförmig ausgebildet sind.

17. Elektrisches Gerät nach Anspruch 15 oder 16, **dadurch gekennzeichnet, dass** Dome (28) mit dem Gehäuseboden (8) einstückig sind.

18. Elektrisches Gerät nach einem der Ansprüche 1 bis 17, **dadurch gekennzeichnet, dass** die Module (2, 3) jeweils eine Schaltungsplatine (10) aufweisen, auf der die Gegensteckverbinder (25, 26) sowie gegebenenfalls die Steckanschlüsse (5, 6) für Aktoren, Sensoren und den Feldbus elektrisch angeschlossen und mechanisch befestigt sind.

19. Elektrisches Gerät nach Anspruch 18, **dadurch gekennzeichnet, dass** die Schaltungsplatine (10) in das Modulgehäuse (7) eingepresst ist.

20. Elektrisches Gerät nach einem der Ansprüche 1 bis 19, **dadurch gekennzeichnet, dass** die Brückenglieder (4) einen zusätzlichen Gerätestecker (33) zum Einspeisen einer Betriebsspannung aufweisen.

21. Elektrisches Gerät nach Anspruch 20, **dadurch gekennzeichnet, dass** die Leiter zur Übertragung der Betriebsspannung nur an einen Steckverbinder (31) jedes Brückengliedes (4) geführt sind.

## Claims

1. Electrical device, in particular a field bus subscriber unit (1) with plug-type connections (5, 6) for actors and/or sensors and the field bus, consisting of attachable modules (2, 3) which comprise a housing (7) and can be mutually connected by means of bridge members (4) to transmit electrical signals and operating voltage, wherein each bridge member (4) comprises two plug connectors (31) and each module comprises two mating plug connectors (25, 26), in the case of terminals optionally also only one mating plug connector, and the plug connectors (31) of each bridge member (4) can be inserted into the two mutually facing mating plug connectors (25, 26) of two adjacently disposed modules (2, 3), **characterised in that** the mating plug connectors (25, 26) are allocated in each case a cylindrical lead-through (19) of the module housing (7) and the plug connectors (31) each comprise a substantially cylindrical outer sleeve (37), on the periphery of which an O-shaped sealing ring (39) is disposed in an annular recess (38), said sealing ring lying under pressure against the wall (20) of the lead-through (19) when the plug connector (31) is inserted.

2. Electrical device, in particular a field bus subscriber unit (1) having plug-type connections (5, 6) for actors and/or sensors and the field bus, consisting of attachable modules (2, 3) which comprise a housing (7) and which can be mutually connected by means of bridge members (4) to transmit electrical signals and operating voltage, wherein each bridge member (4) comprises two plug connectors (31) and each module (2, 3) comprises two mating plug connectors (25, 26), in the case of terminals optionally also only one mating plug connector, and the plug connectors (31) of each bridge member (4) can be inserted into the two mutually facing mating plug connectors (25, 26) of two adjacently disposed modules (2, 3), **characterised in that** the plug connectors are allocated in each case a cylindrical lead-through of the bridge member and the mating plug connectors each comprise a substantially cylindrical outer sleeve, on the periphery of which an O-shaped sealing ring is disposed in an annular recess, said sealing ring lying under pressure against the wall of the lead-through when the plug connector is inserted.

3. Electrical device as claimed in claim 1 or 2, **characterised in that** the outer sleeve (37) is formed in one piece with the bridge member (4) or the module housing (7).

4. Electrical device as claimed in any of claims 1 to 3, **characterised in that** the mutually opposed, approximately mutually parallel sealing ring bearing surfaces (20 40) of the lead-through (19) and of the annular recess (38) are inclined with respect to the plug-in axis.

5. Electrical device as claimed in any of claims 1 to 4, **characterised in that** the module housing (7) comprises a shoulder (17), in the base surface (18) of which the lead-throughs (19) or - in the case of an embodiment according to claim 2 - the outer sleeves are disposed, the height of said shoulder corresponds to the portion of the inserted bridge members (4) which protrudes from the base surface (18) and the depth of said shoulder corresponds approximately to that of the bridge members (4).

6. Electrical device as claimed in any of claims 1 to 5, **characterised in that** the plug-type connections (5, 6) for actors, sensors and the field bus are countersunk in the module housing (7) or are at least approximately flush with the top surface (12) thereof.

7. Electrical device as claimed in any of claims 5 or 6, **characterised in that** in the region of the shoulder (17) in the middle between the lead-throughs (19) or - in the case of an embodiment as claimed in claim 2 - the outer sleeves, the module housing (7) comprises a partition wall (24) and a cross-piece (23) which extends transversely thereto, is flush with the connection-side end surface (22) of the module housing (7) and protrudes laterally slightly beyond the partition wall (24), wherein the height of the cross-piece (23) and the partition wall (24) is at most the same as the height of the shoulder (17).

8. Electrical device as claimed in claim 7, **characterised in that** the cross-piece (23) and the partition wall (24) are formed in one piece with the module housing (7).

9. Electrical device as claimed in any of claims 1 to 8, **characterised in that** the module housings (7) comprise on opposite-lying sidewalls (14, 14') T-shaped projections (15) or corresponding guide slots (16), which are open towards the top surface (12) of the module housing (7), to accommodate the projections (15) at least virtually without any clearance.

10. Electrical device as claimed in any of claims 1 to 9, **characterised in that** the end side of the module housings (7) which lies opposite the shoulder (17) is provided with a surface (13) which is inclined in the manner of a desk to accommodate labelling spaces (43) and display elements (44).

11. Electrical device as claimed in claim 10, **characterised in that** all of the labelling spaces (43) and display elements (44) are disposed on the inclined surface (13).

12. Electrical device as claimed in any of claims 1 to 11, **characterised in that** the module housing (7) comprises feet (9) for support on a mounting surface, whose support surface is spaced apart from the housing base (8).

13. Electrical device as claimed in claim 12, **characterised in that** the feet (9) are formed in one piece with the module housing (7) and are provided with openings (27) for fastening screws.

14. Plug connector as claimed in claim 12 or 13, **characterised in that** the housing base (8) is formed in the shape of a trough and tapers towards the end surfaces (22, 22') of the module housing (7).

15. Electrical device as claimed in any of claims 1 to 14, **characterised in that** the housing base (8) comprises elevations (domes) 28 disposed in the form of a grid.

16. Electrical device as claimed in claim 15, **characterised in that** the domes (28) are formed in a tubular shape.

17. Electrical device as claimed in claim 15 or 16, **characterised in that** domes (28) are formed in one piece with the housing base (8).

18. Electrical device as claimed in any of claims 1 to 17, **characterised in that** the modules (2, 3) each comprise a printed circuit board (10), on which the mating plug connectors (25, 26) and, where appropriate, the plug-type connections (5, 6) for actors, sensors and the field bus are electrically connected and mechanically fixed.

19. Electrical device as claimed in claim 18, **characterised in that** the printed circuit board (10) is pressed into the module housing (7).

20. Electrical device as claimed in any of claims 1 to 19, **characterised in that** the bridge members (4) comprise an additional device plug (33) for applying an operating voltage.

21. Electrical device as claimed in claim 20, **characterised in that** the conductors for transmitting the operating voltage are guided only on to one plug connector (31) of each bridge member (4).

## Revendications

1. Appareil électrique, en particulier unité d'abonné (1) à bus de champ avec prises à enfichage (5, 6) pour acteurs et/ou capteurs et le bus de champ, composé de modules (2, 3) alignables comprenant un boîtier (7) qui peuvent être reliés les uns aux autres par des éléments en pont (4) pour la transmission des signaux électriques et de la tension de fonctionnement, sachant que chaque élément en pont (4) comprend deux connecteurs à enfichage (31) et chaque module (2, 3) comprend deux, pour les terminaux en option uniquement un, contre-connecteurs (25,26), et les connecteurs à enfichage (31) de chaque élément en pont (4) sont enfichables dans les deux contre-connecteurs (25, 26) en vis-à-vis des deux modules (2, 3) disposés l'un à côté de l'autre, **caractérisé en ce qu'**un passage cylindrique (19) du boîtier de module (7) est attribué à chaque fois aux contre-connecteurs (25, 26), et les connecteurs (31) comprennent à chaque fois une gaine externe (37) essentiellement cylindrique sur le pourtour de laquelle est agencé un joint d'étanchéité (39) annulaire dans une cavité circulaire (38), lequel, lorsque le connecteur (31) est enfiché, s'appuie sous l'effet de la pression contre la paroi (20) de la réalisation (19).

2. Appareil électrique, en particulier unité d'abonné (1) à bus de champ avec prises à enfichage (5, 6) pour acteurs et/ou capteurs et le bus de champ, composé de modules (2, 3) alignables comprenant un boîtier (7) qui peuvent être reliés les uns aux autres par des éléments en pont (4) pour la transmission des signaux électriques et de la tension de fonctionnement, sachant que chaque élément en pont (4) comprend deux connecteurs à enfichage (31), et chaque module (2, 3) comprend deux, pour les terminaux en option uniquement un, contre-connecteurs (25,26), et les connecteurs (31) de chaque élément en pont (4) sont enfichables dans les deux contre-connecteurs (25, 26) en vis-à-vis des deux modules (2, 3) disposés l'un à côté de l'autre, **caractérisé en ce qu'**un passage cylindrique de l'élément en pont est attribué à chaque fois aux connecteurs à enfichage, et les contre-connecteurs (31) comprennent à chaque fois une gaine externe essentiellement cylindrique sur le pourtour de laquelle est agencé un joint d'étanchéité annulaire dans une cavité circulaire, lequel, lorsque le connecteur est enfiché, s'appuie sous l'effet de la pression contre la paroi de la réalisation.

3. Appareil électrique selon la revendication 1 ou 2, **caractérisé en ce que** la gaine externe (37) forme une seule pièce avec l'élément en pont (4) et/ou le boîtier de module (7).

4. Appareil électrique selon une des revendications 1 à 3, **caractérisé en ce que** les surfaces d'appui (20, 40) du joint d'étanchéité opposées et approximativement parallèles les unes aux autres du passage (19) et de la cavité (38) circulaire sont inclinées par rapport à l'axe d'enfichage.

5. Appareil électrique selon une des revendications 1 à 4, **caractérisé en ce que** le boîtier de module (7) comporte un épaulement (17) dans la surface de base (18) de laquelle sont disposés les passages (19) ou les gaines externes (lors d'une configuration selon la revendication 2), dont la hauteur correspond à la partie dépassant de la surface de base (18) des éléments en pont (4) enfichés et dont la profondeur correspond approximativement à celle des éléments en pont (4).

6. Appareil électrique selon une des revendications 1 à 5, **caractérisé en ce que** les prises à enfichage (5, 6) pour les acteurs, capteurs et bus de champ sont immergées dans le boîtier de module (7) ou au moins affleurent avec la surface de toit (12) de celui-ci.

7. Appareil électrique selon une des revendications 5 ou 6, **caractérisé en ce que** le boîtier de module (7) dans la zone de l'épaulement (17) centralement entre les passages (19) et/ou les gaines externes (dans le modèle selon la revendication 2), comprend une cloison (24) et une nervure transversale s'étendant transversalement à celle-ci, affleurant avec la surface frontale (22) côté raccord du boîtier de module (7), dépassant latéralement de la cloison (24), la hauteur de la nervure transversale (23) et de la cloison (24) étant aussi élevée que celle de l'épaulement (17).

8. Appareil électrique selon la revendication 7, **caractérisé en ce que** la nervure transversale (23) et la cloison (24) forment une seule pièce avec le boîtier de module (7).

9. Appareil électrique selon une des revendications 1 à 8, **caractérisé en ce que** les boîtiers de module (7) comprennent sur les parois latérales (14, 14') opposées des ergots (15) en forme de T et/ou des fentes de guidage (16) correspondantes ouvertes en direction de la surface du toit (12) du boîtier de module (7) pour le logement au moins pratiquement sans jeu des ergots (15).

10. Appareil électrique selon une des revendications 1 à 9, **caractérisé en ce que** sur la face frontale opposée à l'épaulement (17) du boîtier de module (7) est prévue une surface (13) biseautée en forme de pupitre pour le logement des champs d'inscription (43) et des éléments d'affichage (44).

11. Appareil électrique selon la revendication 10, **caractérisé en ce que** tous les champs d'inscription (43) et les éléments d'affichage (44) sont disposés sur la surface biseautée (13).

12. Appareil électrique selon une des revendications 1 à 11, **caractérisé en ce que** le boîtier de module (7) comprend des pieds (9) pour l'appui sur une surface de montage, dont la surface d'appui est séparée du fond de boîtier (8).

13. Appareil électrique selon la revendication 12, **caractérisé en ce que** les pieds (9) forment une seule pièce avec le boîtier de module (7) et sont dotés d'ouvertures (27) destinées aux vis de fixation.

14. Connecteur selon la revendication 12 ou 13, **caractérisé en ce que** le fond de boîtier (8) est configuré en forme de cuve et se rétrécit vers les surfaces frontales (22, 22') du boîtier de module (7).

15. Appareil électrique selon une des revendications 1 à 14, **caractérisé en ce que** le fond de boîtier (8) comprend des élévations (dômes) (28) disposées en forme de trame.

16. Appareil électrique selon la revendication 15, **caractérisé en ce que** les dômes (28) sont configurés en forme de tubes.

17. Appareil électrique selon la revendication 15 ou 16, **caractérisé en ce que** les dômes (28) forment une seule pièce avec le fond de boîtier (8).

18. Appareil électrique selon une des revendications 1 à 17, **caractérisé en ce que** les modules (2, 3) comprennent respectivement un circuit de commutation (10) sur lequel sont raccordés électriquement et sont fixés mécaniquement les contre-connecteurs (25, 26) et éventuellement les prises à enfichage (5, 6) pour acteurs, capteurs et le bus de champ.

19. Appareil électrique selon la revendication 18, **caractérisé en ce que** le circuit de commutation (10) est enfoncé dans le boîtier de module (7).

20. Appareil électrique selon une des revendications 1 à 19, **caractérisé en ce que** les éléments en pont (4) comprennent un socle connecteur (33) supplémentaire pour l'alimentation d'une tension de fonctionnement.

21. Appareil électrique selon la revendication 20, **caractérisé en ce que** les conducteurs pour la transmission de la tension de fonctionnement sont dirigés uniquement sur un connecteur multiple (31) de chaque élément en pont (4).
